# EUROPÄISCHE PATENTSCHRIFT

(11) **EP 1 042 946 B1**
(45) Veröffentlichungstag und Bekanntmachung des Hinweises auf die Patenterteilung: **23.01.2002**
(21) Anmeldenummer: 98964355.6
(22) Anmeldetag: 12.11.1998
(51) Int. Cl.: H05K 7/00

(54) **HYBRIDSCHALTUNG MIT EINEM SYSTEM ZUR WÄRMEABLEITUNG**
HYBRID CIRCUIT WITH A HEAT DISSIPATION SYSTEM
CIRCUIT HYBRIDE POURVU D'UN SYSTEME DE DISSIPATION DE CHALEUR

(30) Priorität: 23.12.1997 DE 19757612
(43) Veröffentlichungstag der Anmeldung: 11.10.2000
(73) Patentinhaber: TYCO Electronics Logistics AG, 9323 Steinach (CH)
(72) Erfinder: REHNELT, Karl, D-81249 München (DE); TEMPLIN, Frank, D-10367 Berlin (DE); SKURAS, Ingo, D-81477 München (DE)
(74) Vertreter: Klunker . Schmitt-Nilson . Hirsch
(86) Internationale Anmeldenummer: DE9803333
(87) Internationale Veröffentlichungsnummer: WO9934657

(56) Entgegenhaltungen:
- EP-A- 0 371 630
- EP-A- 0 516 096
- DE-A- 19 530 577
- US-A- 4 518 982
- US-A- 4 868 352
- US-A- 5 788 513
- PATENT ABSTRACTS OF JAPAN vol. 096, no. 008, 30. August 1996 (1996-08-30) & JP 08 111472 A (NEC CORP), 30. April 1996 (1996-04-30)
- PATENT ABSTRACTS OF JAPAN vol. 095, no. 008, 29. September 1995 (1995-09-29) & JP 07 130909 A (IBIDEN CO LTD), 19. Mai 1995 (1995-05-19)

## Beschreibung

Die Erfindung betrifft eine Hybridschaltung mit einer insbesondere SMD-fähigen Anschlußanordnung, die mehrere Anschlußpins zum Einlöten der Hybridschaltung in eine Leiterplatte umfaßt, wobei mindestens ein Teil der auf den Leistungsumsatz der Hybridschaltung zurückgehenden Wärmeentwicklung über die Anschlußpins zur Leiterplatte abführbar ist.

Hybrid- oder Schichtschaltungen sind elektronische Subbaugruppen, bei denen planare Leiterbahnstrukturen und passive Bauelemente, insbesondere Widerstände, mittels spezieller Schichttechnologien auf ein Keramiksubstrat aufgebracht werden, wobei diese planaren Strukturen auf dem gemeinsamen Keramiksubstrat mit weiteren Bauelementen, beispielsweise ICs oder Relais', verschaltet bzw. hybridiert werden können. Diese weiteren Bauelemente sind üblicherweise oberflächenmontierbar, das heißt, sie werden in der bekannten SMD-(Surface Mounted Devices)Technik auf Anschlußflecken auf der Hybridschaltung aufgesetzt und dort, meistens durch Reflow-Löten, verlötet.

Hybridschaltungen auf Keramik-Trägermaterial gestatten einen hohen Leistungsumsatz auf geringstem Bauraum. Damit einher geht häufig eine starke Erwärmung der Baugruppe. Diese starke Erwärmung muß von dem Bauteil abgeführt werden. Üblicherweise erfolgt ein Teil der Ableitung über die Bauelementeoberfläche und ein weiterer Teil über die Anschlußpins. Kann die Wärme über die Anschlußpins nicht ausreichend abgeführt werden, bzw. übersteigt die Temperatur die Schmelztemperatur des Lotes mit dem die Pins auf die Leiterplatte eingelötet sind, so lötet sich die Hybridschaltung in der Leiterplatte selbst aus. Wenn die einzelnen Lotstellen aufschmelzen und pastös werden, bleibt zwar die elektrische Verbindung über die einzelnen Anschlußpins noch erhalten, die mechanische Stabilität der Hybridschaltung relativ zur Leiterplatte ist jedoch nicht mehr gegeben.

Dieses Problem ist insbesondere bei SMD-Anwendungen bedeutsam, bei denen die Hybridschaltung als Ganzes selbst wiederum SMD-fähig sein soll. Zur Erzielung einer hohen Integrationsdichte werden Hybridschaltungen heute meist als Single-In-Line-Subbaugruppen in Leiterplatten eingelötet. Um den in der dritten Dimension gegebenen Raum auszunutzen, werden sie also senkrecht zur Leiterplatte bzw. zum Substrat mit nur einer Reihe von Anschlüssen montiert. Das geschilderte Stabilitätsproblem tritt also bei nicht in Durchsteckmontage, sondern in SMD-Technik auf eine Leiterplatte aufgelöteten Single-In-Line-Hybridbaugruppen in besonderem Maße auf. Um die Temperaturerhöhung der Anschlußpins zu begrenzen, wurden deshalb bisher zusätzliche Kühlkörper an die Hybridschaltung montiert bzw. es mußte der Leistungsumsatz im Bauelement stärker begrenzt werden.

Der Erfindung liegt die Aufgabe zugrunde, eine Hybridschaltung der eingangs angegebenen Art zu schaffen, die über ein verbessertes System zur Wärmeableitung und Temperaturbegrenzung ohne Einsatz zusätzlicher Kühlkörper an Hybridschaltungen verfügt.

Diese Aufgabe wird bei einer Hybridschaltung der eingangs angegebenen Art dadurch gelöst, daß mindestens ein Anschlußpin mit einem gegenüber den anderen Anschlußpins derart vergrößerten thermischen Übergangswiderstand zur Hybridschaltung versehen ist, daß dieser Anschlußpin bei gegebenem Leistungsumsatz nicht die Schmelztemperatur des verwendeten Lotes erreicht.

Weiterbildungen der Erfindung sind Gegenstand der Unteransprüche.

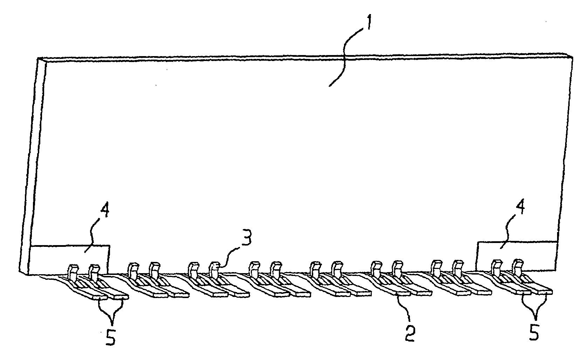

Die Erfindung wird nachfolgend anhand eines Ausführungsbeispiels und der einzigen Figur der Zeichnung, die in Seitenansicht eine erfindungsgemäße Hybridschaltung mit Anschlußanordnung zeigt, näher erläutert.

Erfindungsgemäß wird eine gezielte Steuerung der Wärmeabfuhr über die Anschlußpins dadurch erreicht, daß einige Anschlußpins thermisch isoliert bzw. mit einem größeren thermischen Übergangswiderstand versehen werden, so daß diese Anschlußpins sich auch bei ggf. erhöhter Wärmeentwicklung in der Hybridschaltung nicht selbsttätig auslöten.

Die mehr oder weniger starke thermische Isolation kann vorteilhaft durch eine oder mehrere unter die Anschlüsse der Pins in Dünn- oder Dickschichttechnik gedruckte Zwischenschicht, beispielsweise aus Dielektrikum oder Glas bewirkt sein. Darüber befindet sich die normale Leiterbahn- bzw. Widerstandsschicht, über die der Anschluß der Hybridschaltung an den betreffenden Anschlußpin realisiert wird. Trotz thermischer Isolierung kann demnach, wenn gewollt, vorteilhafterweise die elektrische Verbindung auch zu diesen Anschlußpins aufrechterhalten werden, obwohl natürlich auch Dummy-Pins möglich sind. Durch Selektion einzelner Anschlußpins oder Pingruppen kann ohne weiteres eine gesteuerte Abfuhr der Wärme über die Anschlußpins erfolgen, so daß insbesondere die Wärme gezielt in bestimmte Bereiche der Leiterplatte eingeleitet werden kann.

Die in der Zeichnung dargestellte Anschlußanordnung, oft auch Anschlußkamm genannt, besteht aus einer Anzahl von aus einem Blechbiegestanzteil hergestellten Anschlußpins 2, die jedoch nicht wie dargestellt notwendig paarweise angeordnet sein müssen. Die Hybridschaltung 1 kann, wie dargestellt, beispielsweise zwischen hochgebogenen Zinken 3 eingeklemmt werden, so daß sie insgesamt senkrecht zur gemeinsamen Aufstandsebene der Anschlußpins 2 und damit auch senkrecht zur Substrat- bzw. Leiterplattenebene angeordnet ist. An den Innenseiten der Zinken 3 kann ein Lot-Inlay vorgesehen sein, so daß beim Einlöten der gesamten Anordnung in eine Leiterplatte auch die Lötverbindungen zwischen dem Anschlußkamm und der Hybridschaltung gebildet werden. Wie dargestellt, können vorteilhaft jeweils die äußeren Anschlußpins 5 der Anschlußreihe mit einer Isolierschicht 4 unterlegt sein, so daß die Wärmeabfuhr über die mittleren Anschlußpins 2 erfolgt und ein Auslöten der Hybridschaltung verhindert wird, da die äußeren Pins 5 die Schmelztemperatur des verwendeten Lotes nicht erreichen.

## Patentansprüche

1. Hybridschaltung mit einer insbesondere SMD-fähigen Anschlußanordnung, die mehrere Anschlußpins (2) zum Einlöten der Hybridschaltung (1) in eine Leiterplatte umfaßt, wobei mindestens ein Teil der auf den Leistungsumsatz der Hybridschaltung (1) zurückgehenden Wärmeentwicklung über die Anschlußpins (2) zur Leiterplatte abführbar ist,
**dadurch gekennzeichnet,**
**daß** mindestens ein Anschlußpin (5) mit einem gegenüber den anderen Anschlußpins (2) derart vergrößerten thermischen Übergangswiderstand zur Hybridschaltung (1)versehen ist, daß dieser Anschlußpin (5) bei gegebenem Leistungsumsatz nicht die Schmelztemperatur des verwendeten Lotes erreicht.

2. Hybridschaltung nach Anspruch 1,
**dadurch gekennzeichnet,**
**daß** die mindestens teilweise thermische Isolation des Anschlußpins (5) durch mindestens eine unter die Anschlußschicht des Anschlußpins (5) gedruckte isolierende Zwischenschicht (4) bewirkt ist.

3. Hybridschaltung nach Anspruch 1 oder 2,
**dadurch gekennzeichnet,**
**daß** die Wahl der Position einzelner Anschlußpins (5) oder Pingruppen mit vergrößerten Übergangswiderständen so erfolgt ist, daß die Wärme gezielt in korrespondierende Bereiche der Leiterplatte abführbar ist.

## Claims

1. A hybrid circuit having a terminal arrangement which is in particular suitable for SMD technology and has a plurality of terminal pins (2) for soldering the hybrid circuit (1) to a printed circuit board, at least some of the developed heat attributable to the power conversion of the hybrid circuit (1) being capable of being dissipated through the terminal pins (2) to the printed circuit board, **characterised in that**
at least one terminal pin (5) is provided with a thermal contact resistance to the hybrid circuit (1) which is higher than that of the other terminal pins (2) such that with the given power conversion this terminal pin (5) does not reach the melting point of the solder used.

2. A hybrid circuit according to Claim 1, **characterised in that** the at least partial heat insulation of the terminal pins (5) is brought about by at least one insulating intermediate layer (4) which is printed underneath the connection layer of the terminal pins (5).

3. A hybrid circuit according to Claim 1 or 2, **characterised in that** the choice of position of individual terminal pins (5) or groups of pins having increased contact resistances is carried out such that the heat may be dissipated into corresponding regions of the printed circuit board in a deliberate arrangement.

## Revendications

1. Circuit hybride comportant un agencement de raccordement se prêtant en particulier à un montage en surface, englobant plusieurs broches de connexion (2) pour souder le circuit hybride (1) sur une plaquette à circuits imprimés, au moins une partie de la chaleur produite par le transfert de puissance du circuit hybride (1) pouvant être dissipée par l'intermédiaire des broches de connexion (2) vers la plaquette à circuits imprimés, **caractérisé en ce que**
au moins une broche de connexion (5) présente une résistance de contact thermique par rapport au circuit hybride (1) tellement accrue par rapport aux autres broches de connexion (2) que cette broche de connexion (5) n'atteint pas la température de fusion du métal d'apport utilisé en présence d'un transfert de puissance déterminé.

2. Circuit hybride selon la revendication 1, **caractérisé en ce que** l'isolation thermique au moins partielle de la broche de connexion (5) est assurée par au moins une couche intermédiaire isolante (4) imprimée au-dessous de la couche de connexion des broches de connexion (5).

3. Circuit hybride selon les revendications 1 ou 2, **caractérisé en ce que** le choix de la position des différentes broches de connexion (5) ou des groupes de broches présentant des résistances de contact accrues est fait de sorte que la chaleur peut être dissipée de manière délibérée dans des zones correspondantes de la plaquette à circuits imprimés.
